# EUROPEAN PATENT SPECIFICATION

(11) **EP 0 980 305 B1**
(45) Date of publication and mention of the grant of the patent: **15.12.2004**
(21) Application number: 98920815.2
(22) Date of filing: 02.05.1998
(51) Int. Cl.: B29C 45/02, B29C 45/14, B29C 45/26, H01L 23/28, H01L 21/56

(54) **APPARATUS FOR MOLDING PLASTIC PACKAGES**
GERÄT ZUM FORMEN VON KUNSTSTOFFVERPACKUNGEN
APPAREIL DE MOULAGE DE BOITIERS EN PLASTIQUE

(30) Priority: 06.05.1997 SG 9701389
(43) Date of publication of application: 23.02.2000
(73) Proprietor: Advanced Systems Automation Limited, Singapore 555854 (SG)
(72) Inventor: CHEW, Hwee, Seng, Jimmy, Singapore 439826 (SG); TAN, Peng, Hui, Singapore 509067 (SG)
(74) Representative: Harrison Goddard Foote
(86) International application number: PCT/SG1998/000032
(87) International publication number: WO 1998/050216

(56) References cited:
- EP-A- 0 688 650
- US-A- 3 650 648
- US-A- 4 332 537
- US-A- 4 442 056
- US-A- 4 857 483
- US-A- 5 155 578
- DERWENT ABSTRACT, Accession No. 1994-221149, Class U11, XP002947491 & JP,A,06 155 513 (POLYPLASTICS KK) 3 June 1994
- DERWENT ABSTRACT, Accession No. 1993-097557, Class U11, XP002947492 & JP,A,05 041 396 (TOSHIBA CHEM. CORP.) 19 February 1993.

## Description

### FIELD OF THE INVENTION

The present invention relates to a system for molding plastic packages for semiconductors, such as ball grid array (BGA) packages. The present invention particularly relates to encapsulating integrated circuits on a substrate in plastic packages.

### BACKGROUND OF THE INVENTION

BGA packages promise to overcome the limitations of conventional packages such as quad flat packs (QFP) in cost, power dissipation, speed and input/output (I/O) pin counts. Crucial to deliver these promises is the electronic industry's ability to mold BGA packages reliably and economically with existing surface mount technologies and equipment. In general, BGA packages are smaller and thinner in physical dimension than the conventional packages of equivalent speed and I/O pin counts. Not surprisingly, non-issues such as a wire sweep in conventional packaging technology become significant when BGA packages are adopted for higher speed and I/O pin count applications.

Furthermore, the trend towards building together interconnected systems such as multichip modules (MCM) continues. MCM refers to package having more than one chip in it, combining several to more than a hundred high - performance silicon ICs. with a custom-designed substrate structure. BGA packages work naturally with MCM as the electronic industry have experience assembling standard single-chip modules on printed circuit boards (PCB) with high yield and low cost. Nevertheless, the prevailing practice of using glob top encapsulation for MCMs detracts from the yields and cost advantage of surface mount technologies.

In addition, US 4,857,483 issued to Steffen et al discloses how a thermosetting resin may be injected outside the parting plane of the transfer mold in order to encapsulate integrated circuits mounted on continuous dielectric strips. The protection of the circuits is improved while at the same time, the ability to test the strip is persevered.

EP 0 688 650 Al by Citizen Watch Co Limited teaches how an integrated circuit on a circuit board may be sealed by resin by mounting the circuit board to face downwards in a cavity of a lower metal mold, pressing molten resin through a runner and a pinpoint gate formed at a lower portion of the cavity and pressing on the circuit board to thereby resin seal the IC on the circuit board.

US 5,286,426 issued to Rano, Jr et al. discloses a method for assembling a lead frame between two cavity plates, where the lead frame is mounted on a bottom cavity plate. Guide pins are used to accurately position the lead frame while inaccurate positioning of the lead frames will admit light through pilot holes in the lead frame which will trigger a photo-detector in turn triggering a warning signal.

JP A 61 155 513 by Polyplastics Co describes an IC packaging method where melt resin is permitted and held back by partition walls. The partition walls are retracted to allow the melt resin to flow to the IC when the melt resin has almost fully filled a cavity of a mold having an injection port through which the melt resin was injected.

### OBJECT OF THE INVENTION

It is another object of the present invention to mold plastic packages for semi conductors reliably and economically.

It is another object of the invention to reliably encapsulate the integrated circuits on a substrate in a plastic package whilst minimising the wire sweep problems within the plastic package.

### SUMMARY OF THE INVENTION

The present invention has a top mold, cavity plate and bottom mold for producing a variety of BGA packages using a transfer molding process. The top mold features a network of runners for communicating with at least one sprue. The cavity plate has on the side facing the bottom mold at least one cavity for forming a mold over a substrate sandwiched therebetween when clamped. On the side of the cavity plate facing the top mold is at least one conical channel for receiving resin from the runner. The tip of the conical channel terminates in a submarine gate disposed in the centre of the cavity for introducing resin therein while minimising wire sweep. The network of runner and combination of conical channels encapsulates BGA structures in a variety of matrix reliably and economically.

### BRIEF DESCRIPTION OF THE DRAWINGS

FIG. 1A is a cross section view of a cavity down type ball grid array package where the molded or encapsulation resin is shown in dotted lines.
FIG. 1B is another cross section view of a cavity up type ball grid array package where the overmold resin is also shown in dotted lines.
F1G. 2 is a prior art gate plate molding method for producing encapsulating plastic packages.
FIG. 3 is another prior art removable cavity plate molding method for producing encapsulating plastic packages.
FIG. 4 is yet another prior art globbing method for filling molded resin for plastic packages.
FIG. 5 illustrates the warpage of a matrix BGA substrate resulting from the application of globbing method of molding; subsequent trimming of the substrate into the proper die size is made virtually impossible.
FIG. 6 is a top, elevational view of the present invention where a BGA matrix substrate may be molded using unique runner and conical channel system to achieve superior results.
FIG. 7 is a cross section, elevatlonal view of the present invention according to section A-A in FIG. 6.

### DESCRIPTION OF THE EMBODIMENT OF THE INVENTION

A system for producing encapsulating BGA packages is described. In the following description, numerous specific details are set forth such as sprue, runner and mold plate, etc. in order to provide a thorough understanding of the present invention. It will be obvious to one skilled in the art that the present invention may be practiced without these specific details. In other instances, well-known parts such as those involved with the resin heating and transfer as well as clamping operation of a transfer mold are not shown in order not to obscure the present invention.

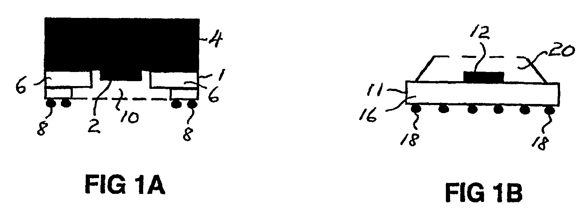

FIGS 1A and 1B are simplified cross sectional views of the two most common structures of the BGA packages. In FIG. 1A, the BGA package is shown in a cavity down configuration. Typical of this range of BGA package is one taught by U.S. Pat. No. 5,583,378. BGA package 1 comprises an integrated chip (IC) 2 attached to a heat sink 4. Not shown in FIG 1A is the details in which the chip 2 is bonded to the substrate 6. It should be understood by one skilled in the art that chip is either wire bonded or TAB leaded to the substrate 6. An array of solder balls 8 is attached to the underside of the BGA package 1. The area between the dotted line and the chip 2 represents a volume 10 to be encapsulated with resin and is the area of interest of the present invention. The prevailing industry practice employs a dam and fill encapsulation process to protect the chip. First, a rectangular dam is optionally dispensed around the die using a high-viscosity encapsulant. Then, a rotary pump dispenses a spiral fill inside the dam using a low-viscosity encapsulant. See, for example CAM/ALOT liquid dispensing systems

Referring to FIG. 1B, BGA package 11 is illustrated in a cavity up configuration. The package 11 Incorporates a IC 12 attached to the upper side of a substrate 16, while an array of solder balls 18 is attached to the under side of the substrate 16. Like the BGA package 1 in FIG. 1A, the details of how the IC is bonded to the substrate is omitted. A volume 20 represents the encapsulation resin. Package 11 exemplifies a broad class of plastic BGA Structures which was pioneered by Motorola and Citizen; they called it Over Molded Plastic Pad Array Carrier.

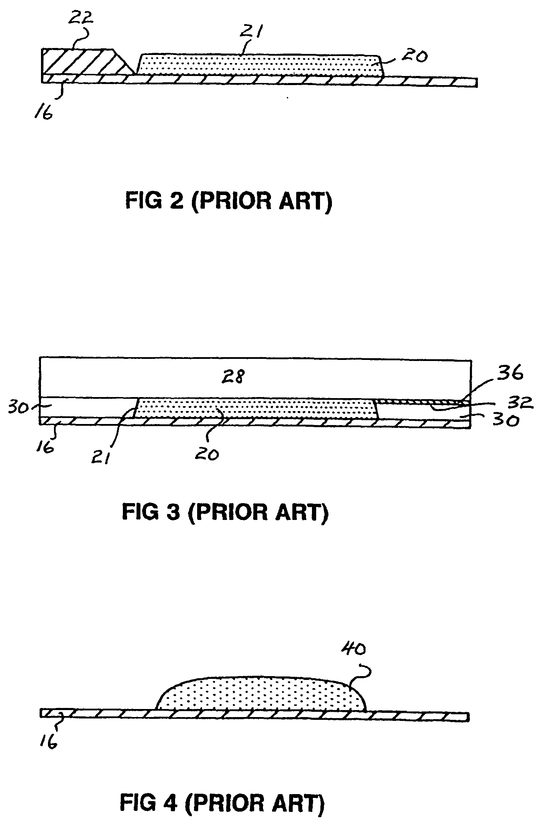

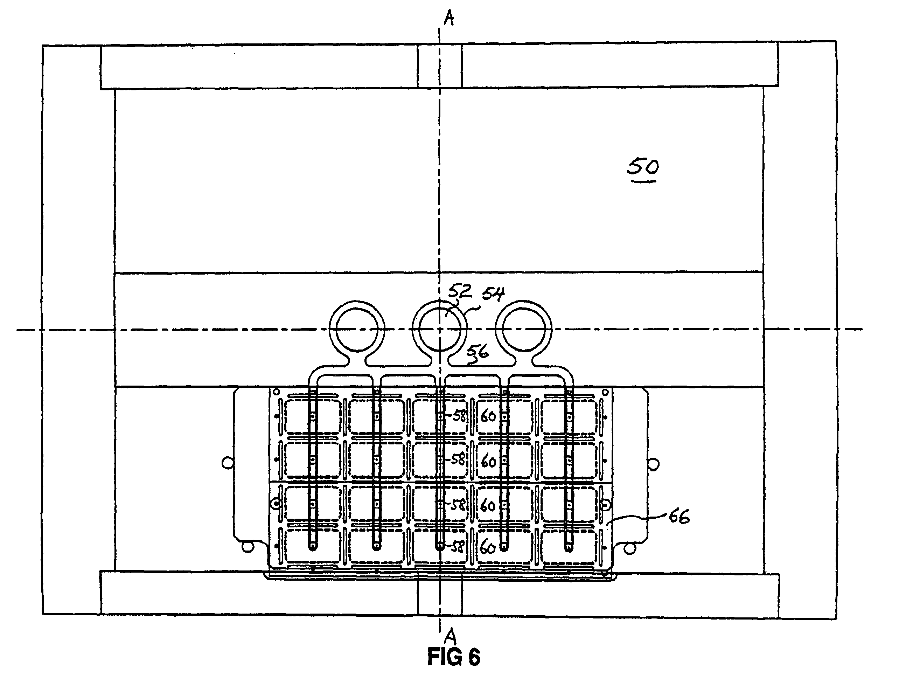

FIGS. 2-4 show graphically prior art molding methods that have been used to encapsulate plastic BGA structures. In FIG. 2, a gate plate molding method for encapsulating plastic packages is illustrated. The package 20 is molded laterally with a gate 22 connected to a cavity 21 (not shown). This approach is described in detail in U.S. Pat. No. 4,442,05.6 issued to Dusan Stepcevic. In FIG. 3, a removable cavity plate 30 incorporating at least a cavity 21 and also a lateral. gate 32 is taught in U.S. Pat. No. 4,332,537 also issued to Dusan Slepcevic for encapsulating-type plastic packages. Finally, FIG. 4 highlights the most popular method in producing BGA packages: glob top method. For instance, see FIG 6 of U.S. Pat. No. 5,358,283 issued to Marrs et al. Glob top encapsulation fills the BGA die by dispensing epoxy in layers in order to prevent trapping air bubbles inside the resin.

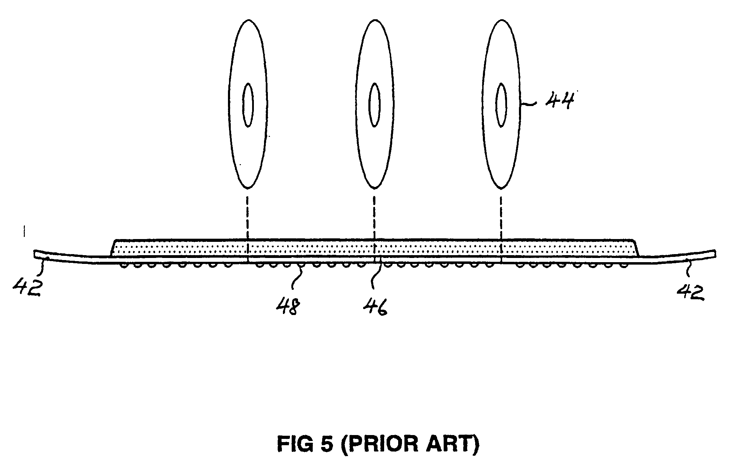

The prior art methods of producing encapsulating plastic packages have a number of limitations which are not easily addressed with existing surface mount technologies and equipment. First, the lateral introduction of encapsulant into the cavity often causes a wire sweep problem in high I/O pin counts BGA packages. Second, in the context of MCM where testing procedures lack standards, electrical problems caused by wire sweep may exacerbate the reliability of such advanced BGA packages. Third, the glob top approach is time consuming and susceptible to quality control problems. The result of encapsulating a BGA matrix substrate by using a glob top method is illustrated in FIG. 5 where the warpage 42 of the substrate is drastic due to a mismatch in the coefficient of thermal expansion of the encapsulant and the substrate. It renders the subsequent trimming of the substrate into individual BGA die difficult or near impossible.

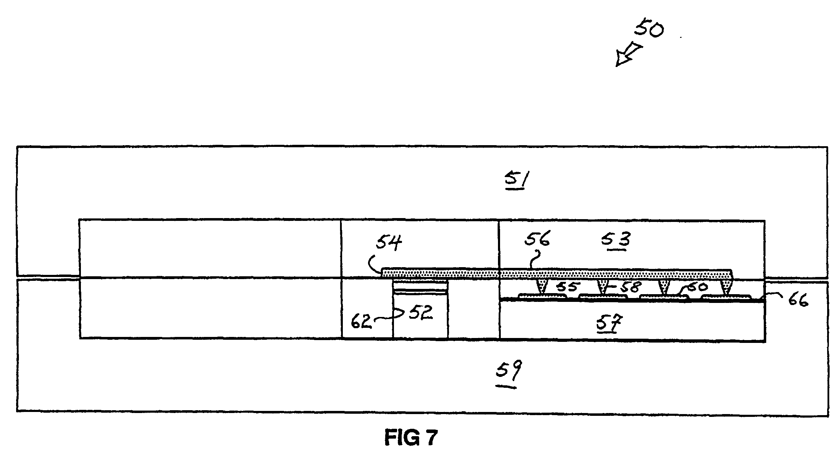

FIGS 6 and 7 are top and side elevational views of the present invention for encapsulating plastic packages. The present invention combines the applicant's know-how in transfer molding for gang-pot mold as well as the removable cavity plate molding technique. It should be understood by one skilled in the art that transfer molding is distinct from injection molding, especially with respect to the exclusive of thermosetting rosins or encapsulants in transfer molding for encapsulating semiconductor devices. In contrast, injection molding equipment is suitable for working with thermoplastic materials. Referring to FIGS 6 and 7, the present invention 50 features a top mold 53, a removable cavity plate 55, and a bottom mold 57 for damping a substrate 66 incorporating a matrix of BGA structures. It should be understood by one skilled in the art that a top mold base 51 and a bottom mold base 59 are usually required to work with the present invention. The mold bases 51 and 59 serve to retain the heat generated by the pot for heating the resin pellets or strips (not shown in the figures).

Again in FIG. 6, the top mold 53 of the present invention comprises at its under side at least one sprue 54 or cull for receiving and redirecting the heated resin which is compressed by a plunger 52. With respect to the substrate 66 which incorporates a matrix of BGA structures 60 thereon, a multiple plunger or gang-pot mold such as the present invention 50 is recommended. In the preferred embodiment of the present invention, the sprue 54 are coupled to a network of runners 56 over the centre portions of the BGA structures. The runners 56 facilitates the flow of resin into the respective cavities below the top mold. As the runners 56 are interconnected, the flow of resin in the runners would be balanced.

In FIG. 7, a cross section view of the removable cavity plate 55 is shown interposed between the top mold 53 and the bottom mold 57. On the surface fronting and flushed with the top mold 53 is at least one conical channel 58 for receiving the flow of resin from the runners. The narrow end of the conical channel 58 terminates preferably in a submarine gate which communicates with at least one cavity 60 for the BGA structure. Referring again to FIG. 7, clamped between the cavity plate 55 and the bottom mold 57 is the substrate 66. The positioning of the conical channel with respect to the cavity is one of the inventive features of the present invention: the introduction of resin from the centre portion of the cavity rather than laterally ensures the now of resin within the cavity is even. The flow of resin is in fact in the same direction as the fan out of either the Wire bonding or TAB leads; as such, the chances of wire sweep occurring is highly unlikely. Furthermore, the attendant problems associated with the increasing viscosity of the flow of rasin within the cavity are also minimised. Overall, the present invention offers the electronic industry an advantages of transfer molding technology without the disadvantages of the conventional cavity molding or plate molding approaches.

The process of encapsulating the BGA substrate is as follows: the plunger 52 in FIG. 7 moves upward in the pot 62 and forces heated resin into the sprue 54 and via the runners 56 and conical channels 58 into the cavities 60. When the plunger 52 detects a back pressure from the network of runners, it Indicates that the resin has filled the cavities completely. The clamping operation of the present invention terminates when the appropriate curing time for the encapsulant has elapsed. The configuration of the removable cavity plate 55 facilitates the smooth breaking of the runner from the cavities, thus reducing the cycle time in encapsulating the BGA substrates.

Although FIGS. 6 and 7 show the encapsulation of a matrix BGA substrate, the present invention may easily be adopted to encapsulate a custom-tailored MCM BGA substrate where the placement of the BGA structure may be random. Thus, the present invention has the flexibillity to cate for a variety of substrates.

While the present invention has been described particularly with reference to FIGS. 1 to 7 with emphasis on a method and apparatus for encapsulating plastic packages with emphasis on BGA packages, it should be understood that the figures are for illustration only and should not be taken as a limitation on the invention. In addition, it is clear that the method and apparatus of the present invention has utility in many applications where packaging of semiconductor devices is required. It is contemplated that many changes and modifications may be made by one of ordinary skill in the art without departing from the scope of the invention as disclosed in the appended claims. For instance, the present invention may be applied in a straight forward manner to others substrates such as ceramic, TAB and etc.

## Claims

1. A system (50) for encapsulating, integrated circuits on a substrate (66) in plastic packages comprising:
a top mold (53) including at least one sprue (54) and at least one runner system (56) for transferring resin from at least one plunger. (52) and pot assembly (62);
a bottom mold (57) for supporting a substrate (66) upon which at least one plastic package is to be made;
a cavity plate (55) interposed between said top mold (53) and said bottom mold (57) for receiving resin from said runner system (56), said cavity plate (55) having on its surface facing said top mold (53) at least one conical channel (58), each of said at least one conical channel (58) having a narrow end communicating with a centre portion of at least one cavity (60) formed around the integrated circuit side of said substrate (66) between said cavity plate (55) and said bottom mold (57), to thereby encapsulate said substrate (66),
whereby said system encapsulates the integrated circuits on said substrate (66) reliably while minimising wire sweep problem within said plastic package.

2. A system according to claim 1 wherein the narrow end of the conical channel (58) terminates in a submarine gate that communicates with the centre portion of at least one cavity (60).

## Patentansprüche

1. System zum Einkapseln von integrierten Schaltkreisen auf einem Substrat (66) in einer Kunststoffverpackung, bestehend aus:
- einer Oberform (53) mit mindestens einem Gießtrichter (54) und mindestens einem Gießkanalsystem (56) zum Abtransport des Kunststoffs von mindestens einer Kolben-Zylinder-Einheit (52/62);
- einer Unterform (57) zur Aufnahme eines Substrats (66), auf dem mindestens eine Kunststoffverpackung herzustellen ist;
- einer Hohlraum-Platte (55), die zwischen der Oberform (53) und der Unterform (57) angeordnet ist zum Aufnehmen des Kunststoffs vom Gießkanalsystem (56), wobei die Hohlraum-Platte (55) an ihrer an der Oberform (53) anliegenden Seite mindestens einen konischen Kanal (58) aufweist, wobei jeder dieser konischen Kanäle (58) ein enges Ende aufweist das mit einem Mittelteil mindestens eines Hohlraums (60) kommuniziert, wobei der Hohlraum (60) um die Seite des integrierten Schaltkreises des Substrates (66) herum zwischen der Hohlraum-Platte (55) und der Unterform (57)geformt ist, wodurch dieses System die integrierten Schaltkreise auf dem Substrat zuverlässig einkapselt, während das Problem der Drahtverwehung (Wire-sweep) vermindert ist.

2. System nach Anspruch 1, bei dem das enge Ende des konischen Kanals (58) in einem eintauchenden Gießzapfen abschließt, der mit dem Mittelteil des mindestens einen Hohlraums (69) kommuniziert.

## Revendications

1. Un système (50) pour enrober des circuits intégrés sur un substrat (66) dans des boîtiers plastiques comprenant :
un moule supérieur (53) comprenant au moins une carotte d'injection (54) et au moins un système de canalisations (56) pour transférer de la résine à partir d'au moins un piston (52) et un ensemble de pots (62);
un moule inférieur (57) pour supporter un substrat (66) sur lequel doit être réalisé au moins un boîtier plastique;
une plaque de cavités (55) interposée entre ledit moule supérieur (53) et ledit moule inférieur (57) pour recevoir la résine venant du dit système de canalisations (56), ladite plaque de cavités (55) ayant, sur sa surface faisant face au dit moule supérieur (53), au moins un canal conique (58), chacun des dits canaux coniques (58) ayant une extrémité étroite communiquant avec une partie centrale d'au moins une cavité (60) réalisée autour du circuit intégré côté du dit substrat (66) entre ladite plaque de cavités (55) et ledit moule inférieur (57), pour enrober ainsi ledit substrat (66);
de sorte que ledit système enrobe les circuits intégrés sur ledit substrat (66) de façon fiable tout en minimisant le problème du balayage des fils à l'intérieur du dit boîtier plastique.

2. Un système selon la revendication 1, dans lequel l'extrémité étroite du canal conique (58) se termine par une porte d'injection sous-marine qui communique avec le centre d'au moins une cavité (60).
